# EUROPEAN PATENT APPLICATION

(11) **EP 2 267 794 A1**
(43) Date of publication of application: **29.12.2010**
(21) Application number: 09709427.0
(22) Date of filing: 06.02.2009
(51) Int. Cl.: H01L 31/05, H01L 31/0224

(54) **SOLAR CELL MODULE AND SOLAR CELL**

(30) Priority: 08.02.2008 JP 2008029421
(71) Applicant: SANYO Electric Co., Ltd., Moriguchi-shi Osaka 560-8677 (JP)
(72) Inventor: TAIRA, Shigeharu, Moriguchi City Osaka 570-8677 (JP)
(74) Representative: Calderbank, Thomas Roger
(86) International application number: PCT/JP2009/052044
(87) International publication number: WO 2009/099179

(57) **Abstract**

A ratio of an area in which a first exposed portion 12b is formed to an area of a first main surface A (a first value v) is smaller than a ratio of an area in which a second exposed portion 13b to an area of the second main surface B (a second value w). A ratio of the first value v to the second value w is smaller than a ratio of a third value x to a fourth value y, where the third value x is a ratio of an area in which the first connecting portion 12a is formed to an area of a region C, and the fourth value y is a ratio of an area in which the second connecting portion 13a is formed to an area of a region D.

## Description

### BACKGROUND OF THE INVENTION

### Field of the Invention

The present invention relates to a solar cell module including a plurality of solar cells connected to one another by a wiring member.

### Description of the Related Art

Solar cells have been expected to be a new energy source, since the solar cells can directly convert clean and inexhaustibly-supplied sunlight into electricity.

Generally, each solar cell outputs power of only approximately several watts. Accordingly, when solar cells are used as a power source for a house, a building or the like, a solar cell module with a plurality of solar cells electrically connected to one another to enhance energy output is used. The plurality of solar cells are sealed with a sealing agent between a light receiving surface side protective member and a back surface side protective member.

The solar cell includes a first connection electrode and a plurality of first fine-line electrodes formed on a light receiving surface of the solar cell, and a second connection electrode and a plurality of second fine-line electrodes formed on a back surface (for example, see Japanese Patent Application Publication No. 2002-359388). The wiring member is soldered to the first connection electrode of one solar cell and the second connection electrode of another solar cell. Thereby, the two solar cells are electrically connected to each other.

Meanwhile, a method of bonding the wiring member to the solar cell by use of a thermosetting resin adhesive which hardens at a lower temperature than a melting temperature of solder has been proposed (for example, see Japanese Patent Application Publication No. 2005-101519). With such a method, influence of temperature change on the solar cell can be reduced compared with a case where the wiring member is soldered.

Here, when the wiring member is bonded to the solar cell, satisfactory connection between the wiring member and the solar cell can be obtained by pressurizing the wiring member toward the solar cell. In other words, electrical and mechanical connection between the wiring member and the first line electrode and between the wiring member and second fine-line electrode can be obtained by making the first and second fine-line electrodes bite into the wiring member.

However, for the purpose of increasing a light receiving areas, the first fine-line electrodes are formed in a smaller number and with a narrower width than the second fine-line electrodes are. For that reason, a ratio of an area of the formed first fine-line electrode to an area of a region to which the wiring member is connected on the light receiving surface is smaller than a ratio of an area of the formed second fine-line electrode to the area of a region to which the wiring member is connected on a back surface. Accordingly, when the wiring member is connected, the amount of bite of the second fine-line electrode into the wiring member is smaller than that of the first fine-line electrode into the wiring member. As a result, when stress depending on a temperature change is applied to the wiring member from a sealing agent having a larger coefficient of linear expansion than that of the wiring member, a malfunction might occur in the electrical and mechanical connection between the second fine-line electrode and the wiring member.

The present invention has been made in view of the above-mentioned circumstances. An object of the present invention is to provide a solar cell module and a solar cell that can maintain satisfactory connection between a wiring member and a fine-line electrode formed on a back surface of a solar cell.

### SUMMARY OF THE INVENTION

In an aspect of the present invention, a solar cell module is summarized as comprising: a solar cell; an one wiring member connected on a light receiving surface of the solar cell; and an other wiring member connected on a back surface opposite to the light receiving surface of the solar cell; wherein the solar cell comprises: a first member group that includes at least a plurality of first fine-line electrodes formed on the light receiving surface; and a second electrode formed on the back surface, the first member group includes a first connecting portion that is connected to the one wiring member and a group of first exposed portion exposed from the one wiring member, the second electrode includes a second connecting portion that is connected to the other wiring member and a second exposed portion exposed from the other wiring member, a first ratio that is a ratio of an area in which the first exposed portion is formed to an area of the light receiving surface is smaller than a second ratio that is a ratio of an area in which the second exposed portion are formed to an area of the back surface, and a ratio of the first ratio to the second ratio is smaller than a ratio of a third ratio to a fourth ratio, the third ratio being a ratio of an area in which the first connecting portion are formed to an area of a region to which the one wiring member is connected on the light receiving surface, the fourth ratio being a ratio of an area in which the second connecting portion are formed to an area of a region to which the other wiring member is connected on the back surface.

In the solar cell module of the aspect of the present invention, the second electrode may have a plurality of second fine-line electrodes, and the plurality of second fine-line electrodes each may have the second connecting, portion and the second exposed portion.

In the solar cell module of the aspect of the present invention, the first connecting portion may be connected to the one wiring member in direct contact with the one wiring member.

In the solar cell module of the aspect of the present invention, the second connecting portion may be connected to the other wiring member in direct contact with the other wiring member.

In the solar cell module of the aspect of the present invention, among the plurality of second fine-line electrodes, at least two second fine-line electrodes may be combined into one in the region to which the other wiring member is connected.

In the solar cell module of the aspect of the present invention, among the plurality of first fine-line electrodes, at least one first fine-line electrode may be branched into a number of lines in the region to which the one wiring member is connected.

In the solar cell module of the aspect of the present invention, the first member group includes an island-shaped member formed into an island shape within the region to which the one wiring member may be connected.

' In an aspect of the present invention, a solar cell module is summarized as comprising: a solar cell; an one wiring member connected on a light receiving surface of the solar cell; and an other wiring member connected on a back surface opposite to the light receiving surface of the solar cell; wherein the solar cell comprises: a first electrode formed on the light receiving surface; and a second electrode formed on the back surface, the first electrode includes a first connecting portion that is connected to the one wiring member and a first exposed portion exposed from the one wiring member,the second electrode includes a second connecting portion that is connected to the other wiring member and a second exposed portion exposed from the other wiring member,an area of the first exposed portion is smaller than an area of the second exposed portion, and a ratio of the area of the first exposed portion to the area of the second exposed portion is smaller than a ratio of an area of the first connecting portion to an area of the second connecting portion.

In an aspect of the present invention, a solar cell is summarized as comprising:a photoerectic conversion body; a first member group including at least a plurality of first fine-line electrodes formed on a first main surface of the photoerectic conversion body; and a second electrode formed on a second main surface of the photoerectic conversion body; wherein an one wiring member is electrically connected to the plurality of first fine-line electrodes, and an other wiring member is electrically connected to the second electrode, the first member group includes a first connecting portion that is connected to the one wiring member and a first exposed portion exposed from the one wiring member,the second electrode includes a second connecting portion that is connected to the other wiring member and a second exposed portion exposed from the other wiring member, a first ratio that is a ratio of an area of the first exposed portion to an area of the first main surface is smaller than a second ratio that is a ratio of an area of the second exposed portion to an area of the second main surface, and a ratio of the first ratio to the second ratio is smaller than a ratio of a third ratio to a fourth ratio, the third ratio being a ratio of an area of the first connecting portion to an area of a region to which the one wiring member is connected on the first main surface, the fourth ratio being a ratio of an area of the second connecting portion to an area of a region to which the other wiring member is connected on the second main surface.

In an aspect of the present invention, a solar cell is summarized as comprising: a photoerectic conversion body; a first electrode formed on a first main surface of the photoerectic conversion body; and a second electrode formed on a second main surface of the photoerectic conversion body; wherein an one wiring member is electrically connected to the first electrode, and an other wiring member is electrically connected to the second electrode, the first electrode includes a first connecting portion that is connected to the one wiring member and a first exposed portion exposed from the one wiring member,the second electrode includes a second connecting portion that is connected to the other wiring member and a second exposed portion exposed from the other wiring member, an area of the first exposed portion is smaller than an area of the second exposed portion, and a ratio of the area of the first exposed portion to the area of the second exposed portion is smaller than a ratio of an area of the first connecting portion to an area of the second connecting portion.

### BRIEF DESCRIPTION OF THE DRAWINGS

Fig. 1 is a side view of a solar cell module 1 according to an embodiment of the present invention;
Fig. 2A and 2B are plan views of a solar cell module 1 according to a first embodiment of the present invention;
Fig. 3 A and 3B are plan views of a solar cell 10 according to the first embodiment of the present invention;
Fig. 4 A and 4B are plan views of a solar cell 10 according to a second embodiment of the present invention;
Fig. 5 A and 5B are plan views of a solar cell 10 according to a third embodiment of the present invention; and
Fig. 6 is a plan view of a light receiving surface side of a solar cell 10 according to an embodiment of the present invention.
Fig. 7 is a plan view of a light receiving surface side of a solar cell 10 according to an embodiment of the present invention.

### DESCRIPTION OF THE PREFERRED EMBODIMENTS

Next, embodiments of the present invention will be described using the drawings. In description of the drawings below, identical or similar reference numerals will be given to identical or similar parts. However, it should be noted that the drawings are schematic and a dimensional ratio and the like is different from actual ones. Accordingly, specific sizes or the like should be determined in consideration of the description below. Moreover, needless to say, there are some differences in dimensional relations and ratios between the mutual drawings.

### [First embodiment]

### (Schematic configuration of solar cell module)

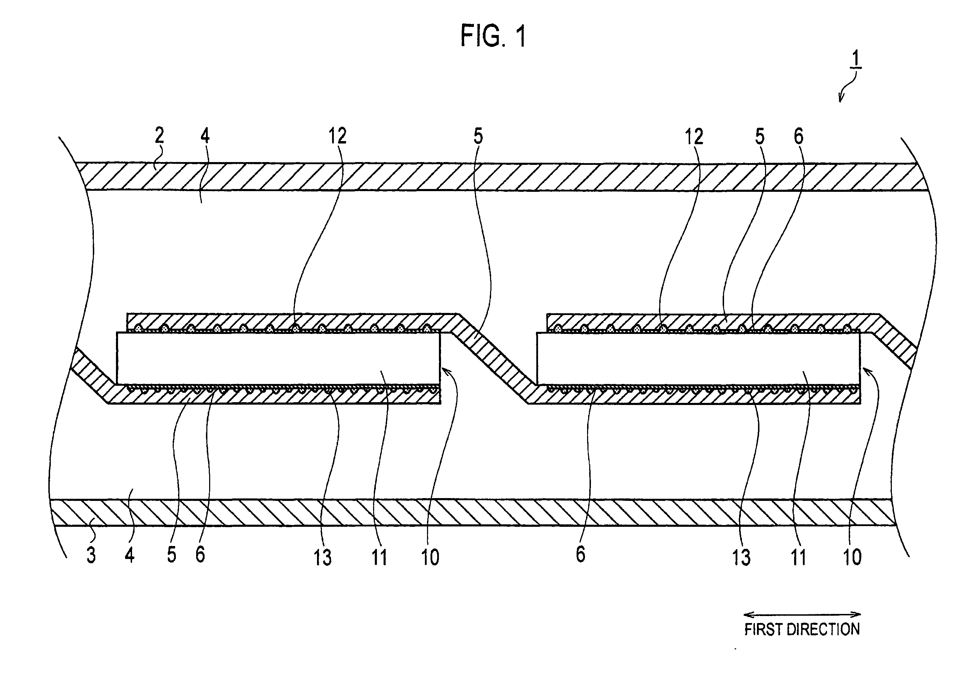

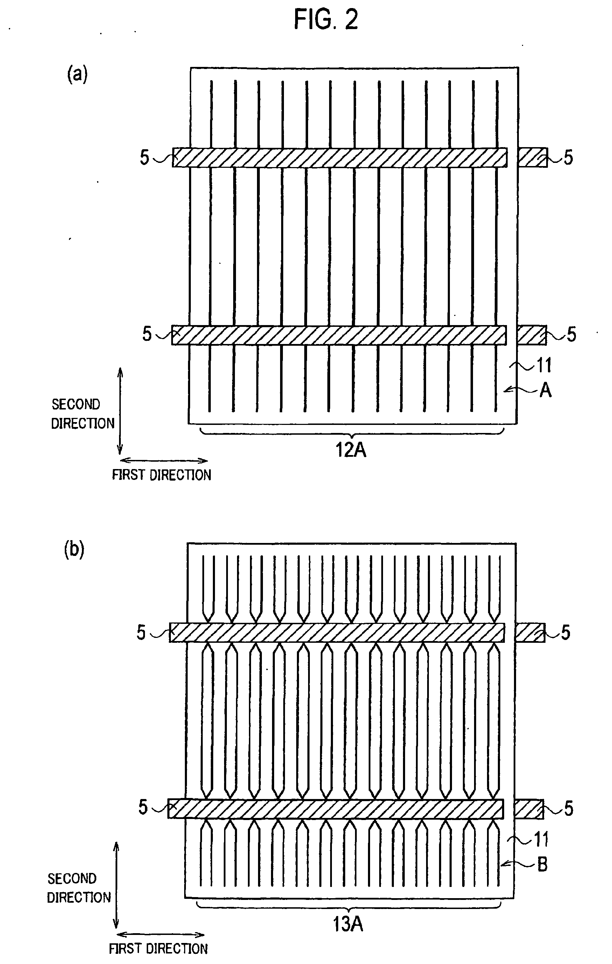

Description will be given of a schematic configuration of a solar cell module 1 according to a first embodiment of the present invention, referring to Figs. 1 and 2. Fig. 1 is a side view of the solar cell module 1 according to the present embodiment. Fig. 2A is a plan view of a light receiving surface side of the solar cell module 1. Fig. 2B is a plan view of a back surface side of the solar cell module 1.

The solar cell module 1 includes a plurality of solar cells 10, a light receiving surface side protective member 2, a back surface side protective member 3, a sealing agent 4, a wiring member 5, and a resin adhesive 6.

The plurality of solar cells 10 are sealed with the sealing agent 4 between the light receiving surface side protective member 2 and the back surface side protective member 3. The plurality of solar cells 10 are arranged in a first direction, and are electrically connected to one another by the wiring member 5.

The solar cell 10 includes a photoelectric conversion body 11, a first electrodes 12, and a second electrodes 13.

The photoelectric conversion body 11 has a first main surface A and a second main surface B provided on a side opposite to the first main surface A. In the present embodiment, the first main surface A is located to be opposite to the light receiving surface side protective member 2, and the second main surface B is located to be opposite to a back surface side protective member 3. In this case, the first main surface A is a light receiving surface of the photoelectric conversion body 11, and the second main surface B is a back surface of the photoelectric conversion body 11.
The photoelectric conversion body 11 generates a photocarrier when receiving the light. The photocarrier refers to an electron hole and electron that are generated by absorption of the light by the photoelectric conversion body 11.

The photoelectric conversion body 11 has, as a basic structure, a semiconductor junction such as a semiconductor pn junction or a semiconductor pin junction. The photoelectric" conversion body 11 can be formed using general semiconductor materials including crystal semiconductor materials such as single crystal Si and polycrystal Si, compound semiconductor materials such as GaAs and InP. The photoelectric conversion body 11 may have a so-called HIT structure, i.e., a structure in which a substantially intrinsic amorphous silicon layer is sandwiched between a monocrystalline silicon substrate and an amorphous silicon layer.

The first electrodes 12 are a collector electrode that collects the photocarrier generated by the photoelectric conversion body 11. As shown in Fig. 2A, the first fine-line electrodes 12A has the plurality of first fine-line electrodes 12A formed approximately all over the first main surface (the light receiving surface) A. The plurality of first fine-line electrodes 12A can be formed by the printing method or the like, for example, by use of a thermosetting or sintering conductive paste.

While in the present embodiment, 13 first fine-line electrodes 12A are formed in a line form in a second direction approximately intersecting the first direction, the number, size, and shape of the first fine-line electrode 12 can be set where relevant depending on size of the photoelectric conversion body 11 and the like.

The second electrodes 13 are a collector electrode that collects the photocarrier generated by the photoelectric conversion body 11. As shown in Fig. 2B, the second fine-line electrodes 13A has the plurality of second fine-line electrodes 13A formed approximately all over the second main surface (the back surface) B. The plurality of second fine-line electrodes 13A can be formed by the same method as in the case of the plurality of first fine-line electrodes 12A.

While 26 second fine-line electrodes 13A are formed in a line in a second direction in the present embodiment, the number, size, and shape of the second fine-line electrode 13A can be set where relevant depending on size of the photoelectric ' conversion body 11 and the like.

The plurality of first fine-line electrodes 12A and the plurality of second fine-line electrodes 13A as mentioned above are directly connected to the wiring member 5 so as to bite into the wiring member 5, as shown in Fig. 1. Configurations of the first electrodes 12 and the second electrodes 13 will be described later.

The light receiving surface side protective member 2 is disposed on the sealing agent 4 to protect a surface of the solar cell module 1. For the light receiving surface side protective member 2, materials having translucency and waterproofness, such as glass, translucency plastics, and the like can be used.

The back surface side protective member 3 is disposed on the sealing agent 4 to protect the back of the solar cell module 1. For the back surface side protective member 3, a resin film such as polyethylene terephthalate (PET), a laminated film having a structure in which an Al foil is sandwiched between resin films and the like can be used.

The sealing agent 4 seals the plurality of the solar cells 10 between the light receiving surface side protective member 2 and the back surface side protective member 3. For the sealing agent 4, resins having translucency, such as EVA, EEA, PVB, silicone resins, urethane resins, acrylic resins, epoxy resins, and the like can be used.

An A1 frame (not shown) can be attached to the outer circumference of the solar cell module 1 having the above-mentioned configuration.

### (Configurations of the first electrode and the second electrode)

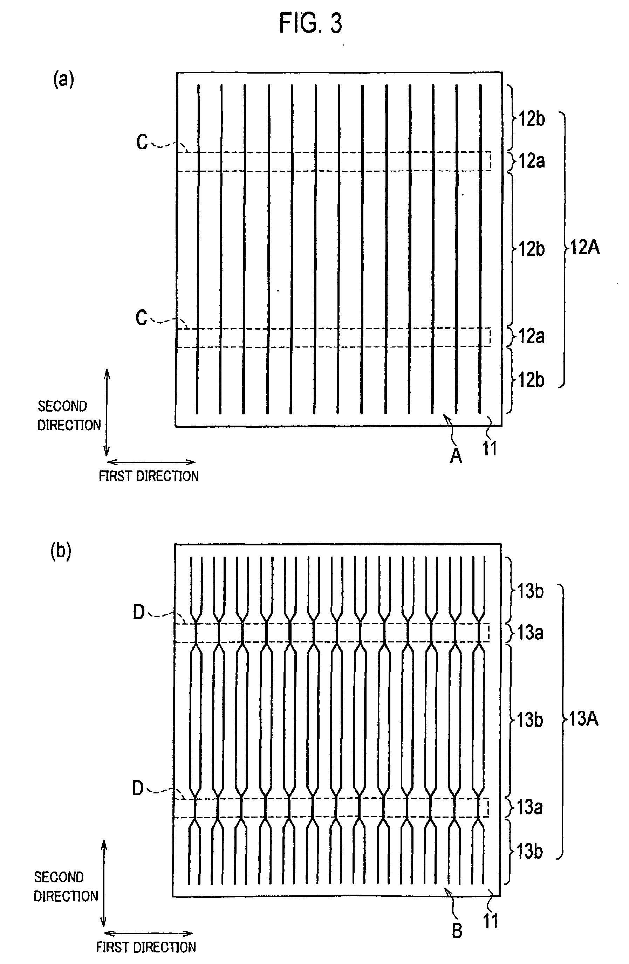

Next, description will be given of configurations of the first electrodes 12 and the second electrodes 13 with reference to Fig. 3A and 3B. Fig. 3A is a plan view of the first main surface (the light receiving surface) A side of the solar cell 10. Fig. 3B is a plan view of the second main surface (the back surface) B side of the solar cell 10.

As shown in Fig. 3A, the 13 first fine-line electrodes 12A each have a first connecting portion 12a that is connected to the wiring member 5, and a first exposed portion 12b exposed from the first main surface A. The first connecting portion 12a is located in a region C to which the wiring member 5 is connected. The wiring member 5 is electrically connected to the first connecting portion 12a. The 13 first fine-line electrodes 12A according to the present embodiment are each formed to have a uniform line width.

As shown in Fig. 3B, the 26 second fine-line electrodes 13A each have a second connecting portion 13a that is connected to the wiring member 5, and a second exposed portion 13b exposed from the second main surface B. The second connecting portion 13a is located in a region D to which the wiring member 5 is connected. The wiring member 5 is electrically connected to the second connecting portion 13a.

Here, the 26 second fine-line electrodes 13A are collected in 13 second connecting portions 13a each by combining two second fine-line electrodes 13A in pair in the region D.

A line width of the second connecting portion 13a and a line width of the second exposed portion 13b according to the present embodiment are approximately the same as the widths of those of the first fine-line electrode 12 (the first connecting portion 12a and the first exposed portion 12b), respectively.

### (Relation of an electrode forming area)

On the basis of the above-mentioned description, the following relation is held between an area in which the first electrodes 12 are formed and an area in which the second electrodes 13 are formed.

First, a first value v is defined as a ratio of an area of the formed first exposed portion 12b to an area of the first main surface A.

Second, a second value w is defined as a ratio of an area of the formed second exposed portion 13b to an area of the second main surface B.

Third, a third value x is defined as a ratio of an area of the formed first connecting portion 12a to an area of the region C.

Fourth, a fourth value y is defined as a ratio of an area of the formed second connecting portion 13a to an area of the region D.

In the above-mentioned case, the first value v is smaller than the second value w. In other words, (v/w) < 1 is fulfilled (hereinafter, "first relation").

This is because an electrode forming area per unit area in the first main surface A is made smaller than that of the second main surface B for the purpose of increasing a light receiving area, and in the second main surface B, an electrode forming area per unit area is made larger than that of the first main surface A for the purpose of decreasing resistive loss.

Moreover, the ratio of the first value v to the second value w is smaller than the ratio of the third value x to the fourth value y. In other words, (v/w) < (x/y) is fulfilled (hereinafter, "second relation").

This is because the electrode forming area per unit area in the region D is brought closer to that in the region C by combining the 26 second fine-line electrodes 13A in pairs in the region D. In other words, this is because the area of the second connecting portion 13A are brought closer to the area of the first connecting portion 12A.

In the present embodiment, since the third value x and the fourth value y are approximately equal, (v/w) < (x/y) ≈ 1 is held.

### (Method of manufacturing a solar cell module)

Next, description will be given of a method of manufacturing the solar cell module 1 according to the present embodiment.

First, using the printing method, the coating method, or the like, a conductive paste is disposed on the first main surface A of the photoelectric conversion body 11 in a pattern shown in Fig. 3A. Subsequently, the conductive paste is temporarily cured by heating.

Next, using the printing method, the coating method, or the like, the conductive paste is disposed on the second main surface B of the photoelectric conversion body 11 in a pattern shown in Fig. 3B. Subsequently, the conductive paste disposed on the first main surface A and the conductive paste disposed on the second main surface B are cured through heat treatment.

Then, the resin adhesive 6 is applied onto the region C and the region D by using a dispenser. Next, the wiring member 5 is disposed on the resin adhesive 6, and the wiring member 5 is heated while the wiring member 5 is pressed against the photoelectric conversion body 11. Thereby, the first connecting portion 12a and the second connecting portion 13a are connected to the wiring member 5, and simultaneously, the resin adhesive 6 is cured. By repeating such connection of the wiring member 5, the plurality of solar cells 10 are electrically connected to one another.

Next, an EVA sheet (sealing agent 4), the plurality of solar cells 10, another EVA sheet (sealing agent 4), and the back surface side protective member 3 are sequentially laminated on a glass substrate (light receiving surface side protective member 2), to form a laminated body. The EVA is cured by heating the laminated body.

### (Operations and effects)

In the solar cell 10 according to the present embodiment, the first electrodes 12 each have the first connecting portion 12a and the first exposed portion 12b, and the second electrodes 13 each have the second connecting portion 13a and the second exposed portion 13b. In this case, the above-mentioned first relation ((v/w) < 1) and the above-mentioned second relation ((v/w) < (x/y)) are fulfilled.

Here, when the first relation is fulfilled, it shows that the electrode forming area per unit area in the first main surface A is made smaller than that in the second main surface B in the solar cell 10. In other words, it shows that the area of the first exposed portion 12b is made smaller than the area of the second exposed portion 13b.

When the first relation is fulfilled and simultaneously the second relation is fulfilled, it shows that the electrode forming area per unit area in the region D is close to the electrode forming area per unit area in the region C.

In the present embodiment, the electrode forming area per unit area in the region D is brought closer to that in the region C by combining the 26 second fine-line electrodes 13A in pairs in the region D.

For that reason, when the wiring member 5 is pressed to be attached to the first main surface A and the second main surface B of the solar cell, a connecting area of the second connecting portion 13a and the wiring member 5 can be brought closer to a connecting area of the first connecting portion 12a and the wiring member 5. Accordingly, the second connecting portion 13a can sufficiently be connected to the wiring member 5.

As a result, even if stress is applied to the wiring member 5 from the sealing agent 4, satisfactory connection between the second connecting portion 13a and the wiring member 5 can be maintained.

### [Second embodiment]

Next, a second embodiment of the present invention will be described with reference to the drawings. A difference between the present embodiment and the first embodiment mentioned above is that the electrode forming area per unit area in the region C is made close to that in the region D. Since other points are the same as those of the first embodiment mentioned above, the difference will be mainly described below.

### (Configurations of the first electrode and the second electrode)

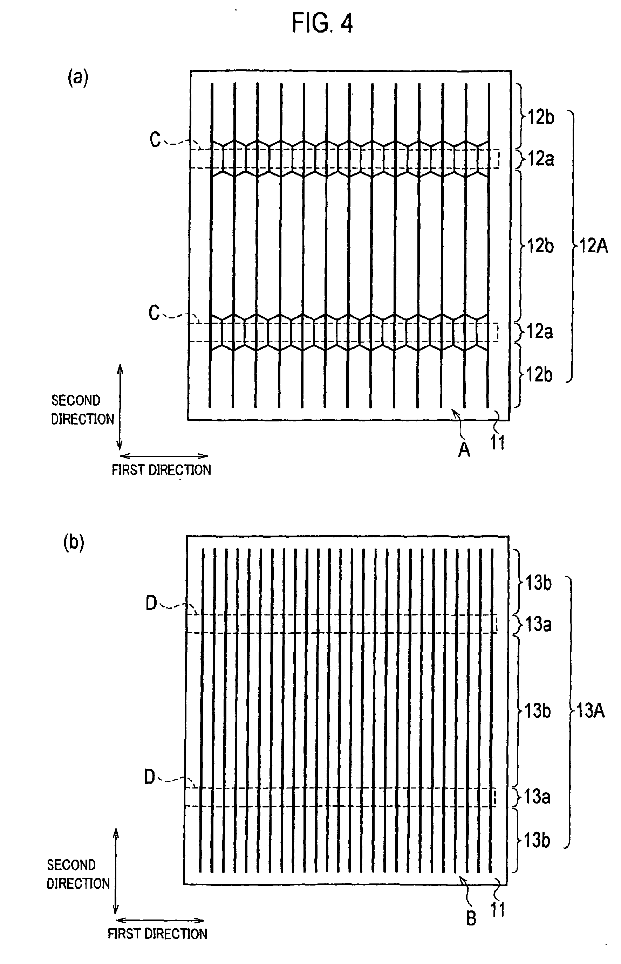

Description will be given of configurations of a first electrodes 12 and a second electrodes 13 according to the present embodiment with reference to Fig. 4A and 4B. Fig. 4A is a plan view of a first main surface (a light receiving surface) A side of a solar cell 10. Fig. 4B is a plan view of a second main surface (a back surface) B side of a solar cell 10.

As shown in Fig. 4A,the first electrodes 12 has 13 first fine-line electrodes 12A. The 13 first fine-line electrodes 12 each have a first connecting portion 12a that is connected to a wiring member 5, and a first exposed portion 12b exposed from the first main surface A. The first connecting portion 12a is located in a region C to which the wiring member 5 is connected.

Here, each of the 13 first fine-line electrodes 12A is branched into plural lines in the region C, and the plural lines are respectively coupled with the 25 first connecting portions 12a. The first connecting portion 12a and the first exposed portion 12b have an approximately equal line width.

As shown in Fig. 4B, the second electrodes 13 has 26 second fine-line electrodes 13A. The26 second fine-line electrodes 13A each have a second connecting portion 13a that is connected to the wiring member 5, and a second exposed portion 13b exposed from the second main surface B. The second connecting portion 13a is located in a region D to which the wiring member 5 is connected. The 26 second fine-line electrodes 13A are each formed to have a uniform line width.

The line width of the first connecting portion 12a and the line width of the first exposed portion 12b according to the present embodiment are approximately the same as the line widths of those of the second fine-line electrode 13 (the second connecting portion 13a and the second exposed portion 13b).

### (Relation of between electrode forming areas)

On the basis of the above-mentioned description, also in the present embodiment, between an area in which the first electrodes 12 are formed and an area in which the second electrodes 13 are formed, the first relation ((v/w) < 1) and the second relation ((v/w) < (x/y)) are fulfilled similarly to the case of the first embodiment mentioned above.

The first relation is fulfilled because the electrode forming area per unit area is made smaller than the second main surface B for the purpose of increasing the light receiving area, and an electrode forming area per unit area in the second main surface B is made larger than that of the first main surface A for the purpose of decreasing the resistive loss.

Moreover, the second relation is fulfilled because the electrode forming area per area in the region C is made closer to that in the region D by branching the 13 first fine-line electrodes 12A in the region C.

### (Operations and effects)

Also in the solar cell 10 according to the present embodiment, the above-mentioned first relation ((v/w) < 1) and the above-mentioned second relation ((v/w) < (x/y)) are fulfilled.

When the first relation is fulfilled, it shows that the electrode forming area per unit area in the first main surface A is made smaller than that of the second main surface B for the purpose of increasing the light receiving area in the solar cell 10. In other words, it shows that the area of the first exposed portion 12b is made smaller than the area of the second exposed portion 13b.

When the first relation is fulfilled and simultaneously the second relation is fulfilled, it shows that the electrode forming are per unit area in the region C is close to the electrode forming area per unit area in the region D.

In the present embodiment, the electrode forming area per unit area in the region C is brought closer to that in the region D by branching the 13 first fine-line electrodes 12A in the region C.

For that reason, when the wiring member 5 is pressed to be attached to the first main surface A and the second main surface B of the solar cell 10, the connecting area of the first connecting portion 12a and the wiring member 5 can be brought closer to the connecting area of the second connecting portion 13a and the wiring member 5. Accordingly, the second connecting portion 13a can be sufficiently connected to the wiring member 5.

As a result, even if the stress is applied to the wiring member 5 from the sealing agent 4, satisfactory connection between the second connecting portion 13a and the wiring member 5 can be maintained.

The 13 first fine-line electrodes 12A are branched at a position spaced from the region C. For that reason, even when the first fine-line electrode 12A is disconnected due to temperature change in the thermal bonding of the wiring member 5, the photocarrier can be collected through a part that is not disconnected.

### [Third embodiment]

Next, a third embodiment of the present invention will be described with reference to the drawings. A difference between the present embodiment and the second embodiment mentioned above is that an island-shaped member 14 is formed in a region C. Since other points are the same as those of the second embodiment mentioned above, the difference will be mainly described below.

### (Configurations of the first electrode and the second electrode)

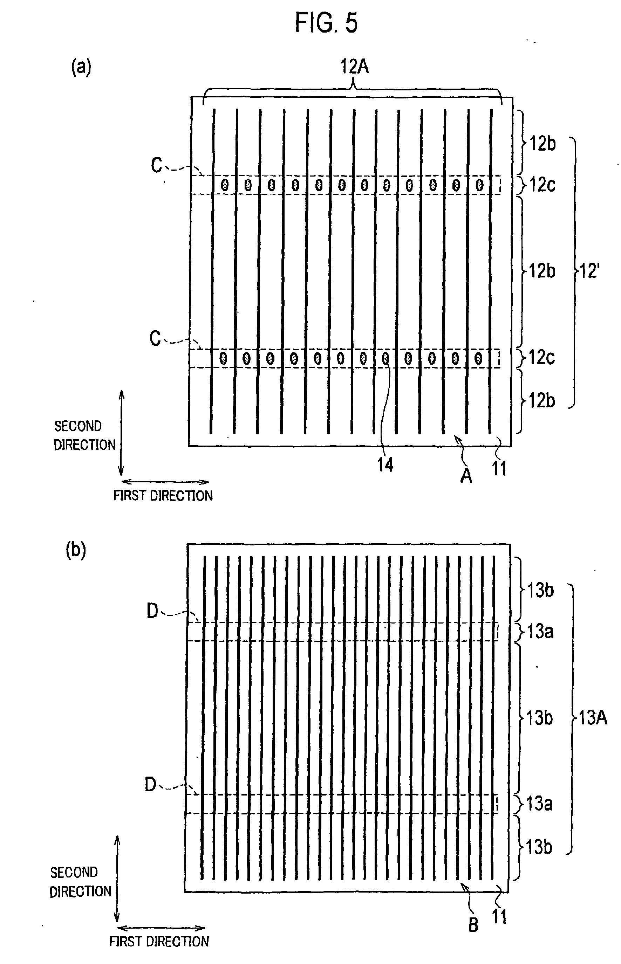

Description will be given of configurations of a first electrodes 12 and a second electrodes 13 according to the present embodiment with reference to Fig. 5A and 5B. Fig. 5A is a plan view of a first main surface A side of a solar cell 10. Fig. 5B is a plan view of a second main surface B side of a solar cell 10.

As shown in Fig. 5A, the first electrodes 12 has the 13 first fine-line electrodes 12A on the light receiving surface A. Furthermore, on the light receiving surface A, the 24 island-shaped members 14 are formed in addition to the 13 first fine-line electrodes 12A. Hereinafter, the 13 first fine-line electrodes 12A and the 24 island-shaped members 14 are collectively referred to as a "first member group 12'."

The first member group 12' has first connecting portion 12c that is connected to a wiring member 5, and first exposed portion 12b exposed from the first main surface A. Here, the first connecting portion 12c according to the present embodiment include parts of the respective 13 first fine-line electrodes 12A and the 24 island-shaped members 14.

The island-shaped member 14 can be formed using a material having insulation, such as silicon oxide or the like. A planar shape of such an island-shaped member 14 will not be limited to an ellipse shown in Fig. 5A, and may be, for example, a dot shape or a rectangular shape. The area of one formed island-shaped member 14 according to the present embodiment is approximately the same as that of one second connecting portion 13a formed in a region D. In addition, the thickness of one formed island-shaped member 14 of the present embodiment is approximately the same as that of the first fine-line electrode 12A.

### (Relation between the first member group and the electrode forming area)

On the basis of the above-mentioned description, similarly to the case of the second embodiment mentioned above, the first relation ((v/w) < 1) and the second relation ((v/w) < (x/y)) are fulfilled between an area of the first member group 12' formed and an area of plurality of second fine-line electrodes 13A formed.

The first relation is fulfilled because the electrode forming area per unit area in the first main surface A is made smaller than that in the second main surface B for the purpose of increasing the light receiving area, and an electrode forming area per unit area in the second main surface B is made larger than that of the first main surface A for the purpose of decreasing the resistive loss.

Moreover, the second relation is fulfilled because the area of the first member group 12' formed per area in the region C is made closer to the electrode forming area per area in the region D by forming a plurality of the island-shaped members 14 in the region C.

### (Operations and effects)

Also in the solar cell 10 according to the present embodiment, the above-mentioned first relation ((v/w) < 1) and the above-mentioned second relation ((v/w) < (x/y)) are fulfilled.

When the first relation is fulfilled, it shows that the electrode forming area per unit area in the first main surface A is made smaller than that of the second main surface B for the purpose of increasing the light receiving area in the solar cell 10. In other words, it shows that the area of the first exposed portion 12b is made smaller than the area of the second exposed portion 13b.

When the first relation is fulfilled and simultaneously the second relation is fulfilled, it shows that the area of the first member group 12' formed per area in the region C is close to the electrode forming area per area in the region D.

In the present embodiment, the area of the first member group 12' per unit area formed in the region C is brought closer to the electrode forming area per unit area in the region D by forming the plurality of the island-shaped members 14 in the region C.

For that reason, when the wiring member 5 is pressed to be attached to the first main surface A and the second main surface B of the solar cell 10, the connecting area of the first connecting portion 12a and the wiring member 5 (including the plurality of the island-shaped members 14) can be brought closer to the connecting area of the second connecting portion 13a and the wiring member 5. Accordingly, the second connecting portion 13a can be sufficiently connected into the wiring member 5.

As a result, even if stress is applied to the wiring member 5 from the sealing agent 4, satisfactory connection between the second connecting portion 13a and the wiring member 5 can be maintained.

### (Other embodiments)

Although the present invention has been described using the above-mentioned embodiments, it should not be understood that the invention is limited by the statements and drawings that constitute a part of this disclosure. From this disclosure, various alternative embodiments, examples, and implementation techniques will be obvious to those skilled in the art.

For example, in the above-mentioned embodiments, the first and second fine-line electrodes are formed in a line in the second direction, but the shape of the fine-line electrode will not be limited to this. For example, fine-line electrodes having a wavy line shape can be formed in a grid pattern.

Moreover, in the first embodiment mentioned above, the two second fine-line electrodes 13A are combined into one, but not less than three second fine-line electrodes 13A may be combined into one.

Moreover, in the second embodiment mentioned above, one first fine-line electrode 12A is branched into three lines, but one first fine-line electrode 12A may be branched into 2 lines or not less than 4 lines.

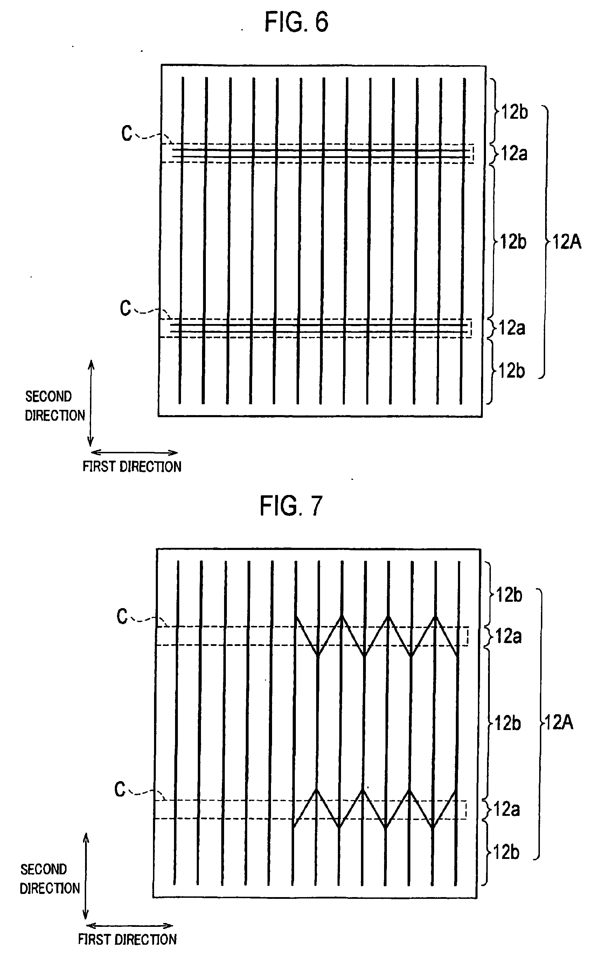

Additionally, in the second embodiment mentioned above, the first fine-line electrode 12 is branched at a position spaced from the region C, but the first fine-line electrode 12 may be branched within the region C. Specifically, the first connecting portion 12a can be formed as shown in Fig. 6. Moreover, as shown in Fig. 7, the branched part may not be in the first direction, and may be formed in a zigzag manner. Furthermore, when branched within the region C, preferably, the first fine-line electrode 12A is branched in a region where an end part of the wiring member 5 is pressed for adhesion. This can suppress peeling off of the first fine-line electrode 12A from the end part of the wiring member 5.

Moreover, in the third embodiment mentioned above, the island-shaped member 14 is formed using a member having insulation, but the island-shaped member 14 may be formed using the same conductive paste as that used for the fine-line electrode.

Moreover, in the second to fourth embodiment mentioned above, the second electrodes 13 have the plurality of second fine-line electrodes 13A, but the shape of the second fine-line electrode 13A is not limited to be the same. For example, the second electrode 13 may be an electrode formed approximately all over the second main surface (the back surface) B.

As described above, apparently, the present invention includes various embodiments and the like that have not been described here. Consequently, the technical scope of the present invention will be determined only by specified matters of invention according to the appropriate scope of claims from the above-mentioned description.

### [Examples]

Hereinafter, examples of a solar cell module according to the present invention will be specifically described. However, the present invention will not be limited to those shown in the following examples, and the invention can be modified where relevant and can be implemented without deviating from the scope of the present invention.

### (Example 1)

First, an n type single crystal silicon substrate of 108 mm square, having a thickness of 150 µm and a resistivity of 1 Ωcm was prepared.

Next, an i type amorphous silicon layer having a thickness of 5 nm and a p type amorphous silicon layer having a thickness of 5 nm were sequentially formed on a light receiving surface of the substrate by using the RF plasma CVD. Subsequently, an i type amorphous silicon layer having a thickness of 5 nm and an n type amorphous silicon layer having thickness of 5 nm were sequentially formed on a back surface of the substrate. Conditions of an RF plasma CVD apparatus were set at a frequency of 13.56 MHz, a forming temperature of 100 °C to 200°C, a reaction pressure of 20 Pa to 80 Pa, and an RF power of 10 W to 100 W.

Next, using the magnetron sputtering method, an ITO film having a thickness of 100 nm was formed on each of the p type and the n type amorphous silicon layers. Conditions of a sputtering apparatus was set at a forming temperature of 50°C to 200°C, an Ar gas flow rate of 200 sccm, an oxygen gas flow rate of 50 sccm, a power of 0.5 kW to 3 kW, and a magnetic field strength of 500 gauss to 3000 gauss. A photoelectric conversion body was produced with the above-mentioned procedure.

Then, using the screen printing method, an epoxy thermosetting type silver paste was printed on the light receiving surface of the solar cell in a pattern shown in Fig. 3A. Specifically, 52 fine-line electrodes (100 µm wide) were formed at a pitch of 2 mm. The silver paste was temporarily cured by heating the silver paste for 5 minutes at 150°C.

Next, the epoxy thermosetting type silver paste was printed on the back surface of the solar cell in a pattern shown in Fig. 3B. Specifically, 104 fine-line electrodes (100 µm wide) were formed at a pitch of 1 mm, and simultaneously, in a region to which a wiring member was to be connected, 52 fine-line electrodes were formed at a pitch of 2 mm by combining the 104 fine-line electrodes in pairs. Next, the silver pastes on the light receiving surface and on the back surface, respectively, were cured by heating the silver pastes at 200°C for 1 hour.

Next, by using a dispenser, an epoxy resin containing nickel particles of approximately 5 volume % was applied onto the regions of the light receiving surface and back surface to which the wiring member was to be connected, so as to have a thickness of 30 µm. Instead of applying the epoxy resin, a tape-shaped epoxy resin formed into tape like may be placed on the regions to which the wiring member was to be connected on the light receiving surface and the back surface.

Subsequently, the wiring member was disposed on the coated epoxy resin, and heated at 200 °C for approximately 1 hour under pressure of approximately 2 MPa. Thereby, the fine-line electrodes bit into the wiring member, while the epoxy resin was cured. A solar cell string was produced by repeating this procedure.

Next, the solar cell string disposed between glass and a PET film was sealed with EVA. As mentioned above, 1000 pieces of the solar cell modules according to example 1 were produced.

### (Example 2)

Next, 1000 pieces of solar cell modules according to example 2 were produced. A difference between example 2 and the above-mentioned example 1 was that the silver pastes were printed in patterns shown in Fig. 4A and 4B in example 2.

Specifically, using the screen printing method, the epoxy thermosetting type silver paste was printed on the light receiving surface of the solar cell in the pattern shown in Fig. 4A. Specifically, 52 fine-line electrodes (100 µm wide) were formed at a pitch of 2 mm, and simultaneously, 104 fine-line electrodes were formed at a pitch of 1 mm by branching one fine-line electrode into two lines in a region to which the wiring member was to be connected.

Moreover, the epoxy thermosetting silver paste was printed on the back surface of the solar cell in the pattern shown in Fig. 4B. Specifically, 104 fine-line electrodes (100 µm wide) were formed at a pitch of 1 mm. Other points were the same as those of example 1 mentioned above.

### (Comparative example)

Next, 1000 pieces of solar cell modules according to comparative example 1 were produced. A difference between comparative example 1 and the above-mentioned example 1 was that the fine-line electrode was not branched or combined in the region to which the wiring member was to be connected.

In other words, in comparative example 1, 52 fine-line electrodes having a linear shape were formed on the light receiving surface, and 104 fine-line electrodes having a linear shape were formed on the back surface. Other points were the same as those of example 1 mentioned above.

### (Temperature cycling test)

A temperature cycling test was performed on the solar cells according to example 1, example 2, and comparative example by using a constant temperature bath, and comparisons were made in an output drop rate of the solar cells after the test. The following table shows the measurement results. Each of values in the following table is an average value of 1000 pieces of the solar cells.

The temperature cycling test was performed based on specifications of JIS C 8917. Specifically, while each sample was held in the constant temperature bath, a temperature was raised from 25°C to 90°C over 45 minutes, and was left at 90°C for 90 minutes. Subsequently, the temperature was lowered to -40°C over 90 minutes, left at -40°C for 90 minutes, and further raised to 25°C over 45 minutes. This procedure was defined as one cycle (6 hours), and 600 cycles were performed.

**[Table 1]**

| | Output drop rate (%) |
|---|---|
| Example 1 | 4.2 |
| Example 2 | 4.0 |
| Comparative example | 4.9 |

As shown in the above table, the output drop rates of the solar cells according to example 1 and example 2 were smaller than that of the solar cell according to comparative example.

In the solar cell according to example 1, this is because the electrode forming area per unit area in the wiring member connection region of the back surface was brought closer to that of the light receiving surface. Additionally, in the solar cell according to example 2, this is because the electrode forming area per unit area in the wiring member connection region of the light receiving surface was brought closer to that of the back surface. In other words, in the solar cells according to example 1 and example 2, the above-mentioned first relation ((v/w) < 1) and the above-mentioned second relation ((v/w) < (x/y)) are fulfilled.

By contrast, in the solar cell according to comparative example, the above-mentioned second relation ((v/w) < (x/y)) is not fulfilled, but a relation of (v/w) = (x/y) is fulfilled. For that reason, the amount of bite of the fine-line electrode into the wiring member on the back surface was smaller than the amount of bite of the fine-line electrode into the wiring member on the light receiving surface. As a result, when stress depending on change in temperature was applied from the sealing agent (EVA) having a larger coefficient of linear expansion than that of the wiring member, a failure occurred in connection between the fine-line electrode and the wiring member on the back surface.

As mentioned above, it was confirmed that satisfactory electrical and mechanical connection between the fine-line electrodes and the wiring member on the back surface can be maintained, when the first relation ((v/w) < 1) was fulfilled, and simultaneously the second relation ((v/w) < (x/y)) was fulfilled.

### INDUSTRIAL APPLICABILITY

As described above, the present invention can provide a solar cell module capable of maintaining satisfactory connection between a wiring member and a fine-line electrode formed on a back surface of a solar cell. Therefore, the present invention is useful for photovoltaic generation field.

## Claims

1. A solar cell module comprising:
a solar cell;
an one wiring member connected on a light receiving surface of the solar cell; and
an other wiring member connected on a back surface opposite to the light receiving surface of the solar cell; wherein
the solar cell comprises: a first member group that includes at least a plurality of first fine-line electrodes formed on the light receiving surface; and a second electrode formed on the back surface,
the first member group includes a first connecting portion that is connected to the one wiring member and a group of first exposed portion exposed from the one wiring member,
the second electrode includes a second connecting portion that is connected to the other wiring member and a second exposed portion exposed from the other wiring member,
a first ratio that is a ratio of an area in which the first exposed portion is formed to an area of the light receiving surface is smaller than a second ratio that is a ratio of an area in which the second exposed portion are formed to an area of the back surface, and
a ratio of the first ratio to the second ratio is smaller than a ratio of a third ratio to a fourth ratio, the third ratio being a ratio of an area in which the first connecting portion are formed to an area of a region to which the one wiring member is connected on the light receiving surface, the fourth ratio being a ratio of an area in which the second connecting portion are formed to an area of a region to which the other wiring member is connected on the back surface.

2. The solar cell module according to claim 1, wherein the second electrode has a plurality of second fine-line electrodes, and
the plurality of second fine-line electrodes each have the second connecting portion and the second exposed portion.

3. The solar cell module according to claim 1 or 2, wherein the first connecting portion is connected to the one wiring member in direct contact with the one wiring member.

4. The solar cell module according to claim 1 or 2, wherein the second connecting portion is connected to the other wiring member in direct contact with the other wiring member.

5. The solar cell module according to claim 2, wherein among the plurality of second fine-line electrodes, at least two second fine-line electrodes are combined into one in the region to which the other wiring member is connected.

6. The solar cell module according to claim 1 or 2, wherein among the plurality of first fine-line electrodes, at least one first fine-line electrode is branched into a number of lines in the region to which the one wiring member is connected.

7. The solar cell module according to claim 1 or 2, wherein the first member group includes an island-shaped member formed into an island shape within the region to which the one wiring member is connected.

8. A solar cell module comprising:
a solar cell;
an one wiring member connected on a light receiving surface of the solar cell; and
an other wiring member connected on a back surface opposite to the light receiving surface of the solar cell; wherein
the solar cell comprises: a first electrode formed on the light receiving surface; and a second electrode formed on the back surface,
the first electrode includes a first connecting portion that is connected to the one wiring member and a first exposed portion exposed from the one wiring member,
the second electrode includes a second connecting portion that is connected to the other wiring member and a second exposed portion exposed from the other wiring member,
an area of the first exposed portion is smaller than an area of the second exposed portion, and
a ratio of the area of the first exposed portion to the area of the second exposed portion is smaller than a ratio of an area of the first connecting portion to an area of the second connecting portion.

9. A solar cell comprising:
a photoerectic conversion body;
a first member group including at least a plurality of first fine-line electrodes formed on a first main surface of the photoerectic conversion body; and
a second electrode formed on a second main surface of the photoerectic conversion body; wherein
an one wiring member is electrically connected to the plurality of first fine-line electrodes, and an other wiring member is electrically connected to the second electrode,
the first member group includes a first connecting portion that is connected to the one wiring member and a first exposed portion exposed from the one wiring member,
the second electrode includes a second connecting portion that is connected to the other wiring member and a second exposed portion exposed from the other wiring member,
a first ratio that is a ratio of an area of the first exposed portion to an area of the first main surface is smaller than a second ratio that is a ratio of an area of the second exposed portion to an area of the second main surface, and
a ratio of the first ratio to the second ratio is smaller than a ratio of a third ratio to a fourth ratio, the third ratio being a ratio of an area of the first connecting portion to an area of a region to which the one wiring member is connected on the first main surface, the fourth ratio being a ratio of an area of the second connecting portion to an area of a region to which the other wiring member is connected on the second main surface.

10. A solar cell comprising:
a photoerectic conversion body;
a first electrode formed on a first main surface of the photoerectic conversion body; and
a second electrode formed on a second main surface of the photoerectic conversion body; wherein
an one wiring member is electrically connected to the first electrode, and an other wiring member is electrically connected to the second electrode,
the first electrode includes a first connecting portion that is connected to the one wiring member and a first exposed portion exposed from the one wiring member,
the second electrode includes a second connecting portion that is connected to the other wiring member and a second exposed portion exposed from the other wiring member,
an area of the first exposed portion is smaller than an area of the second exposed portion, and
a ratio of the area of the first exposed portion to the area of the second exposed portion is smaller than a ratio of an area of the first connecting portion to an area of the second connecting portion.
